(19) Europäisches Patentamt
European Patent Office
Office européen des brevets

(11) EP 4 793 236 A1

(12) EUROPEAN PATENT APPLICATION
published in accordance with Art. 153(4) EPC

(43) Date of publication:
**19.08.2026 Bulletin 2026/34**

(21) Application number: **24877141.2**

(22) Date of filing: **07.10.2024**

(51) International Patent Classification (IPC):
***C01G 25/02*** *(2006.01)* ***C09K 3/14*** *(2006.01)*
***H01L 21/304*** *(2006.01)*

(52) Cooperative Patent Classification (CPC):
**C01G 25/02; C09K 3/14; H10P 52/00**

(86) International application number:
**PCT/JP2024/035740**

(87) International publication number:
**WO 2025/079546 (17.04.2025 Gazette 2025/16)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **13.10.2023 JP 2023177734**

(71) Applicant: **Daiichi Kigenso Kagaku Kogyo Co., Ltd.**
**Osaka-shi, Osaka 541-0041 (JP)**

(72) Inventors:
- **TAKASAKI, Fumiyuki**
**Osaka-shi, Osaka 559-0025 (JP)**
- **ASAHI, Kiyoaki**
**Osaka-shi, Osaka 559-0025 (JP)**
- **NISHIKAWA, Taku**
**Osaka-shi, Osaka 559-0025 (JP)**

(74) Representative: **Cabinet Beau de Loménie**
**103, rue de Grenelle / CS 90800**
**75340 Paris Cedex 07 (FR)**

# (54) ZIRCONIA SOL AND METHOD FOR PRODUCING ZIRCONIA SOL

(57) This zirconia sol has a crystallite diameter A on a monoclinic (-111) plane of 5.0-50.0 nm, a crystallite diameter B on a monoclinic (111) plane of 5.0-50.0 nm, and a crystallite diameter ratio X represented by formula 1 of 0.5-0.95. Formula 1: [crystallite diameter ratio X]=[crystallite diameter A on the monoclinic (-111) plane]/[crystallite diameter B on the monoclinic (111) plane]; the crystallite diameter A and the crystallite diameter B are values calculated from powder X-ray diffraction measurement and analysis of said measurement.

Fig.1

m(-111)
m(111)
CPS
20
25
30
35
40
2θ(°)



Processed by Luminess, 75001 PARIS (FR)

## Description

TECHNICAL FIELD

The present invention relates to zirconia sol and a method for producing zirconia sol.

BACKGROUND ART

Zirconia sol is used as a raw material powder for fine ceramics, precision polishing agents, cosmetics, paint fillers, zirconia thin films, and the like (see, for example, Patent Documents 1 to 5).

PRIOR ART DOCUMENT

PATENT DOCUMENTS

Patent Document 1: JP-A-2006-324639
Patent Document 2: WO 2012/169515 A
Patent Document 3: WO 06/123562 A
Patent Document 4: JP-A-02-137732
Patent Document 5: JP-A-05-24844

SUMMARY OF THE INVENTION

PROBLEMS TO BE SOLVED BY THE INVENTION

An object of the present invention is to provide zirconia sol that is more suitable as abrasive grains for polishing. Another object of the present invention is to provide a method for producing the zirconia sol.

MEANS FOR SOLVING THE PROBLEMS

The present invention provides the following.

[1] Zirconia sol in which

a crystallite diameter A on a monoclinic (-111) plane is 5.0 nm or more and 50.0 nm or less,
a crystallite diameter B on a monoclinic (111) plane is 5.0 nm or more and 50.0 nm or less, and
a crystallite diameter ratio X represented by the following Formula 1 is 0.5 or more and 0.95 or less:

[crystallite diameter ratio X] = [crystallite diameter A on monoclinic (-111) plane]/[crystallite diameter B on monoclinic (111) plane] <Formula 1>

where the crystallite diameter A and the crystallite diameter B are values calculated from powder X-ray diffraction measurement and analysis of the measurement.

Since the crystallite diameter A is 5.0 nm or more and the crystallite diameter B is 5.0 nm or more, it is possible to suppress burying in a polishing pad and to maintain the polishing rate high.

In addition, since the crystallite diameter A is 50.0 nm or less and the crystallite diameter B is 50.0 nm or less, the resistance to penetration into a polished surface or a pad interface can be reduced. Since the resistance to penetration can be reduced, the instantaneous pressure applied to a contact can be reduced. As a result, the polishing rate can be maintained high, and the surface roughness of the surface to be polished can be reduced.

In addition, since the crystallite diameter ratio X is 0.95 or less, the polishing rate can be maintained high. Regarding the reason for this, the present inventors infer as follows.

When the crystallite diameter ratio X is 0.95 or less, the monoclinic crystal is a rectangular prism or rod shape having a larger aspect ratio. The rectangular prism or rod-shaped crystal is less likely to turn as compared with a spherical crystal (a crystal having a crystallite diameter ratio X of 1). As a result, the frictional resistance against the surface to be

polished increases, and an effect of improving the polishing rate is exhibited.

The zirconia sol in which the crystallite diameter A is 5.0 nm or more and 50.0 nm or less, the crystallite diameter B is 5.0 nm or more and 50.0 nm or less, and the crystallite diameter ratio X is 0.5 or more and 0.95 or less can be expected to have a higher rate and higher smoothness (lower surface roughness) than those of existing products in precise polishing of semiconductors and the like. In particular, in polishing of SiC or the like having high hardness, a higher rate and higher smoothness (lower surface roughness) than those of existing products can be expected.

Furthermore, the present invention provides the following.

[2] The zirconia sol according to [1], including a tetragonal phase in a volume fraction of 2.0% or more and 90.0% or less.

When the tetragonal phase is contained in a volume fraction of 2.0% or more and 90.0% or less, the surface roughness of the surface to be polished can be further reduced while a high polishing rate is maintained. Regarding the reason for this, the present inventors infer as follows.

The tetragonal phase has a property to undergo phase transition to a monoclinic phase due to pressure, and is accompanied by volume expansion by several percent during phase transition to a monoclinic phase. Therefore, when the zirconia sol is exposed to pressure at the interface between a pad and a surface to be polished, a part of the tetragonal phase undergoes phase transition to a monoclinic crystal, and the aggregation of crystallites cleaves due to the volume expansion at that time, and the aggregation is loosened. Due to this, the exposure pressure is relaxed. As a result, it is intermittently generated during polishing, so that the instantaneous overpressure on the surface to be polished by abrasive grains for polishing is suppressed, and the surface roughness can be reduced.

Furthermore, the present invention provides the following.

[3] The zirconia sol according to [1] or [2], in which a crystallite diameter ratio Y represented by the following Formula 2 is 0.3 or more and 1.2 or less:

[crystallite diameter ratio Y] = [crystallite diameter A on monoclinic (-111) plane]/[crystallite diameter C on tetragonal (101) plane] <Formula 2>

where the crystallite diameter C is a value calculated from powder X-ray diffraction measurement and analysis of the measurement.

When the crystallite diameter ratio Y is 0.3 or more and 1.2 or less, the surface roughness of the surface to be polished can be further reduced. Regarding the reason for this, the present inventors infer as follows.

When the crystallite diameter ratio Y is 0.3 or more and 1.2 or less, the phase transition is easily induced. That is, the instantaneous overpressure is further suppressed. As a result, the surface roughness is further reduced.

Furthermore, the present invention provides the following.

[4] The zirconia sol according to any one of [1] to [3] in which

the particle diameter $D_{50}$ is within a range of 5 nm or more and less than 50 nm, and
the proportion X attained by the following procedure is 40% or more:
<Procedure> a transmission electron microscope image in which 20 or more isolated particles are included is obtained;
the following operations 1) through 5) are carried out with respect to each isolated particle in the transmission electron microscope image:

1) a circumscribed circle and an inscribed circle which has the same center as that of the circumscribed circle are obtained;
2) a ratio of the diameter of the obtained circumscribed circle and the diameter of the obtained inscribed circle [(diameter of circumscribed circle)/(diameter of inscribed circle)] is obtained;
3) the ratio defined above [(diameter of circumscribed circle)/(diameter of inscribed circle)] is obtained for all the isolated particles in the transmission electron microscope image;
4) the number of isolated particles A having a ratio [(diameter of circumscribed circle)/(diameter of inscribed circle)] of 2.0 or more is counted;
5) the proportion X of the isolated particles A to all the isolated particles is obtained:

(proportion X (%)) = [(number of isolated particles A)/(number of all isolated particles)] × 100.

It can be said that the particle having a ratio [(diameter of circumscribed circle)/(diameter of inscribed circle)] of 2.0 or more is a particle having a further angular distorted shape. According to the configuration of [4], the proportion X is 40% or more and a certain number or more of particles having an angular distorted shape are contained. Zirconia sol having such particles is more useful as abrasive grains for polishing.

Furthermore, the present invention provides the following.
[5] A method for producing the zirconia sol according to any one of [1] to [4], including step A of adding ammonia water dropwise to an aqueous zirconium oxychloride solution to neutralize,
in which

(1) the concentration of the aqueous zirconium oxychloride solution before performing the step A is 10% by mass or more, and the temperature thereof is 60°C or more and 95°C or less,
(2) the concentration of the ammonia water is 10% by mass or more,
(3) the volume of droplets of the ammonia water to be dropped in the step A is 1.0 ml or less,
(4) the dropwise addition of the ammonia water is performed in two stages, and in a first stage, the ammonia water is added dropwise in an amount of 0.9 mol or more and 1.1 mol or less in terms of $NH_3$ per 1 mol of Zr, and then the resulting solution is held for 10 minutes or more and 120 minutes or less, and
(5) in a second stage, the ammonia water is further added dropwise, and then the resulting solution is held for 10 minutes or more and 240 minutes or less,
(6) during the dropwise addition of the ammonia water and during the holding, the temperature of the aqueous zirconium oxychloride solution is maintained within a range of ±5°C with respect to the temperature thereof at the start of the dropwise addition.

According to the configuration of [5], in the step A of neutralization, ammonia water with a concentration within a specific range, the volume of droplets of which is controlled within a specific range, is added dropwise to an aqueous zirconium oxychloride solution having a concentration within a specific range. Specifically, ammonia water having a concentration of 10% by mass or more is added dropwise to an aqueous zirconium oxychloride solution having a concentration of 10% by mass or more. The volume of droplets of the ammonia water to be added dropwise is 1.0 ml or less. Thereby, the zirconia sol of [1], that is, zirconia sol in which the crystallite diameter A is 5.0 nm or more and 50.0 nm or less, the crystallite diameter B is 5.0 nm or more and 50.0 nm or less, and the crystallite diameter ratio X is 0.5 or more and 0.95 or less can be obtained.
The temperature of the aqueous zirconium oxychloride solution before the step A is performed is 60°C or more and 95°C or less. The temperature mainly affects the crystallite diameter. The higher the temperature is, the larger the crystallite diameter A on the monoclinic (-111) plane and the crystallite diameter B on the monoclinic (111) plane are. Since the temperature is 60°C or more, the crystallite diameter A can be made to 5.0 nm or more and the crystallite diameter B can be made to 5.0 nm or more.
In particular, the dropwise addition of the ammonia water is performed in two stages.
In the first stage, the ammonia water is added dropwise in an amount of 0.9 mol or more and 1.1 mol or less in terms of $NH_3$ per 1 mol of Zr, and then the resulting solution is held for 10 minutes or more and 120 minutes or less. The holding time after the dropwise addition of the ammonia water in the first stage mainly affects the crystallite diameter ratio X. The longer the holding time is, the smaller the crystallite diameter ratio X can be made. That is, by setting the holding time to 10 minutes or more, the crystallite diameter ratio X can be made to 0.95 or less. Even if the holding time is made longer than 120 minutes, it is impossible to reduce the crystallite diameter ratio X more greatly as compared with the case of holding for 120 minutes. Therefore, from the viewpoint of productivity, the holding time is 120 minutes or less.
In addition, during the dropwise addition of the ammonia water and during the holding, the temperature of the aqueous zirconium oxychloride solution is maintained within a range of ±5°C with respect to the temperature thereof at the start of the dropwise addition. The temperature mainly affects the crystallite diameter. The higher the temperature is, the larger the crystallite diameter A on the monoclinic (-111) plane and the crystallite diameter B on the monoclinic (111) plane are. Since the temperature is 60°C or more, the crystallite diameter A can be made to 5.0 nm or more and the crystallite diameter B can be made to 5.0 nm or more.
As described above, according to the configuration of [5], many particles having a distorted shape are obtained by the use as a raw material of the zirconium hydroxide obtained through the control of the above (1) to (6). That is, zirconia sol in which the crystallite diameter A is 5.0 nm or more and 50.0 nm or less, the crystallite diameter B is 5.0 nm or more and 50.0 nm or less, and the crystallite diameter ratio X is 0.5 or more and 0.95 or less can be obtained.
Furthermore, the present invention provides the following. [6] The method for producing the zirconia sol according to [5], in which the holding time in the second stage is 30 minutes or more and 240 minutes or less.
The holding time after the dropwise addition of the ammonia water in the second stage mainly affects the crystallite diameter ratio Y. The longer the holding time is, the more the content of the tetragonal phase can be increased. In addition, the longer the holding time is, the smaller the crystallite diameter ratio Y can be made. That is, by setting the holding time to 30 minutes or more, the crystallite diameter ratio Y can be made to 1.2 or less. In addition, even if the holding time is made longer than 240 minutes, it is impossible to reduce the crystallite diameter ratio Y more greatly as compared with the case of holding for 240 minutes. Therefore, from the viewpoint of productivity, the holding time is 240 minutes or less.

## EFFECT OF THE INVENTION

According to the present invention, it is possible to provide zirconia sol which is more suitable as abrasive grains for polishing. It is possible to provide a method for producing the zirconia sol.

## BRIEF DESCRIPTION OF THE DRAWINGS

Fig. 1 is an X-ray diffraction chart of Example 1.
Fig. 2 is an X-ray diffraction chart of Example 5.
Fig. 3 is a diagram for explaining the circumscribed circle and the inscribed circle of an isolated particle in a transmission electron microscope image.

## MODE FOR CARRYING OUT THE INVENTION

Hereinafter, embodiments of the present invention will be described. However, the present invention is not limited only to these embodiments. Zirconia (zirconium oxide) as referred to herein is common zirconia and contains 10% by mass or less of impurity metal compounds including hafnia. In addition, the terms "comprise" and "contain" as used herein include the concepts of "comprise", "contain", "substantially consist of", and "consist of".

[Zirconia sol]

Hereinafter, one example of the zirconia sol according to the present embodiment will be described. However, the zirconia sol of the present invention is not limited to the following example.
The zirconia sol according to the present embodiment has:

a crystallite diameter A on a monoclinic (-111) plane of 5.0 nm or more and 50.0 nm or less,
a crystallite diameter B on a monoclinic (111) plane of 5.0 nm or more and 50.0 nm or less, and
a crystallite diameter ratio X represented by the following Formula 1 of 0.5 or more and 0.95 or less:

[crystallite diameter ratio X] = [crystallite diameter A on monoclinic (-111) plane]/[crystallite diameter B on monoclinic (111) plane] <Formula 1>

where the crystallite diameter A and the crystallite diameter B are values calculated from powder X-ray diffraction measurement and analysis of the measurement.

Since the crystallite diameter A is 5.0 nm or more and the crystallite diameter B is 5.0 nm or more, it is possible to suppress burying in a polishing pad and to maintain the polishing rate high.
In addition, since the crystallite diameter A is 50.0 nm or less and the crystallite diameter B is 50.0 nm or less, the resistance to penetration into a polished surface or a pad interface can be reduced. Since the resistance to penetration can be reduced, the instantaneous pressure applied to a contact can be reduced. As a result, the polishing rate can be maintained high, and the surface roughness can be reduced.
The crystallite diameter A is preferably 7.0 nm or more, and more preferably 9.0 nm or more.
The crystallite diameter A is preferably 40.0 nm or less, and more preferably 35.0 nm or less.
The crystallite diameter A is preferably 7.0 nm or more and 40.0 nm or less, and more preferably 9.0 nm or more and 35.0 nm or less.
The crystallite diameter B is preferably 7.0 nm or more, and more preferably 9.0 nm or more.
The crystallite diameter B is preferably 40.0 nm or less, and more preferably 35.0 nm or less.
The crystallite diameter B is preferably 7.0 nm or more and 40.0 nm or less, and more preferably 9.0 nm or more and 35.0 nm or less.
As described above, the crystallite diameter ratio X is 0.5 or more and 0.95 or less. When the crystallite diameter ratio X is 0.95 or less, the polishing rate can be maintained high. Regarding the reason for this, the present inventors infer as follows.
When the crystallite diameter ratio X is 0.95 or less, the monoclinic crystal is a rectangular prism or rod shape having a larger aspect ratio. The rectangular prism or rod-shaped crystal is less likely to turn as compared with a spherical crystal (a crystal having a crystallite diameter ratio X of 1). As a result, the frictional resistance against the surface to be

polished increases, and an effect of improving the polishing rate is exhibited.

The crystallite diameter ratio X is preferably 0.55 or more, and more preferably 0.58 or more.

The crystallite diameter ratio X is preferably 0.9 or less, and more preferably 0.87 or less.

The crystallite diameter ratio X is preferably 0.55 or more and 0.9 or less, and more preferably 0.58 or more and 0.87 or less.

From the above description, the zirconia sol in which the crystallite diameter A is 5.0 nm or more and 50.0 nm or less, the crystallite diameter B is 5.0 nm or more and 50.0 nm or less, and the crystallite diameter ratio X is 0.5 or more and 0.95 or less can be expected to have a higher rate and higher smoothness (lower surface roughness) than those of existing products in precise polishing of semiconductors and the like. In particular, in polishing of SiC or the like having high hardness, a higher rate and higher smoothness (lower surface roughness) than those of existing products can be expected.

The zirconia sol preferably contains a tetragonal phase in a volume fraction of 2.0% or more and 90.0% or less.

When the tetragonal phase is contained in a volume fraction of 2.0% or more and 90.0% or less, the surface roughness of the surface to be polished can be further reduced while a high polishing rate is maintained. Regarding the reason for this, the present inventors infer as follows.

The tetragonal phase has a property to undergo phase transition to a monoclinic phase due to pressure, and is accompanied by volume expansion by several percent during phase transition to a monoclinic phase. Therefore, when the zirconia sol is exposed to pressure at the interface between a pad and a surface to be polished, a part of the tetragonal phase undergoes phase transition to a monoclinic crystal, and the aggregation of crystallites cleaves due to the volume expansion at that time, and the aggregation is loosened. Due to this, the exposure pressure is relaxed. As a result, it is intermittently generated during polishing, so that the instantaneous pressurization on the surface to be polished by abrasive grains for polishing is suppressed, and the surface roughness can be reduced.

The content of the tetragonal phase is more preferably 5.0% or more, and still more preferably 8.0% or more.

The content of the tetragonal phase is more preferably 85.0% or less, and still more preferably 80.0% or less.

The content of the tetragonal phase is more preferably 5.0% or more and 85.0% or less, and still more preferably 8.0% or more and 80.0% or less.

The tetragonal crystal may not be necessarily contained, but when the tetragonal crystal is present, the surface roughness of the surface to be polished can be further reduced.

In the zirconia sol, it is preferable that the crystallite diameter ratio Y represented by the following Formula 2 is 0.3 or more and 1.2 or less.

[crystallite diameter ratio Y] = [crystallite diameter A on monoclinic (-111) plane]/[crystallite diameter C on tetragonal (101) plane] <Formula 2>

where the crystallite diameter C is a value calculated from powder X-ray diffraction measurement and analysis of the measurement.

When the crystallite diameter ratio Y is 0.3 or more and 1.2 or less, the surface roughness of the surface to be polished can be further reduced. Regarding the reason for this, the present inventors infer as follows.

When the crystallite diameter ratio Y is 0.3 or more and 1.2 or less, the phase transition is easily induced. That is, the instantaneous overpressure is further suppressed. As a result, the surface roughness is further reduced.

The crystallite diameter ratio Y is more preferably 0.4 or more, and still more preferably 0.5 or more.

The crystallite diameter ratio Y is more preferably 1.1 or less, and still more preferably 1.0 or less.

The crystallite diameter ratio Y is more preferably 0.4 or more and 1.1 or less, and still more preferably 0.5 or more and 1.0 or less.

In the zirconia sol, it is preferable that

the particle diameter $D_{50}$ is within the range of 5 nm or more and less than 50 nm, and
the proportion X attained by the following procedure is 40% or more.

<Procedure>

A transmission electron microscope image in which 20 or more isolated particles are included is obtained.

The following operations 1) through 5) are carried out with respect to each isolated particle in the transmission electron microscope image.

1) A circumscribed circle and an inscribed circle which has the same center as that of the circumscribed circle are obtained.
2) A ratio of the diameter of the obtained circumscribed circle and the diameter of the obtained inscribed circle

[(diameter of circumscribed circle)/(diameter of inscribed circle)] is obtained.

3) The ratio defined above [(diameter of circumscribed circle)/(diameter of inscribed circle)] is obtained for all the isolated particles in the transmission electron microscope image.

4) The number of isolated particles A having a ratio [(diameter of circumscribed circle)/(diameter of inscribed circle)] of 2.0 or more is counted.

5) The proportion X of the isolated particles A to all the isolated particles is obtained:

(proportion X (%)) = [(number of isolated particles A)/(number of all isolated particles)] $\times$ 100.

The particle diameter $D_{50}$ is preferably 45 nm or less, and more preferably 40 nm or less.

The particle diameter $D_{50}$ is preferably 7 nm or more, and more preferably 9 nm or more.

The particle diameter $D_{50}$ is preferably 7 nm or more and 45 nm or less, and more preferably 9 nm or more and 40 nm or less.

The method for measuring the particle diameter $D_{50}$ is, in more detail, the method described in Examples.

The proportion X is preferably 50% or more, more preferably 55% or more, and still more preferably 60% or more.

It is more preferable as the proportion X is larger, but the proportion X is, for example, 99% or less, 90% or less, or the like.

The proportion X is preferably 50% or more and 99% or less, more preferably 55% or more and 90% or less, and still more preferably 60% or more and 85% or less.

The proportion X is, in more detail, a value attained by the method described in Examples.

It can be said that the particle having a ratio [(diameter of circumscribed circle)/(diameter of inscribed circle)] of 2.0 or more is a particle having a further angular distorted shape. Zirconia sol having such particles is more useful as abrasive grains for polishing.

The concentration of the zirconia sol is not particularly limited, but is usually 1% by mass or more and 60% by mass or less in terms of $ZrO_2$. When the concentration of the zirconia sol is 1% by mass or more, it is possible to prevent the zirconia concentration from becoming low in the case of performing dilution with another solvent. When the concentration of the zirconia sol is 60% by mass or less, thickening of the sol is suppressed, and the sol is superior in stability.

The concentration of the zirconia sol is more preferably 5% by mass or more, and still more preferably 10% by mass or more.

The concentration of the zirconia sol is more preferably 50% by mass or less, and still more preferably 45% by mass or less.

The concentration of the zirconia sol is more preferably 5% by mass or more and 50% by mass or less, and still more preferably 10% by mass or more and 45% by mass or less.

The dispersion medium of the zirconia sol is not particularly limited, and examples thereof include water, hydrophilic organic solvents such as methanol, ethanol, 2-propanol, acetone, and ether, and mixtures of one or more of the hydrophilic organic solvents. As the dispersion medium for the zirconia sol, preferably, water (pure water or ion-exchanged water) is usually used.

The pH of the dispersion medium for the zirconia sol is not particularly limited, but is preferably 1 or more and 13 or less, and more preferably 2 or more and 12 or less. When an acid such as nitric acid is contained, the pH of the dispersion medium is more preferably 7 or less, or 1 or more and 6 or less. When the pH of the dispersion medium for the zirconia sol is 7 or less, the pH is far different from the isoelectric point of zirconia, and the stability is improved.

In the present description, the zirconia sol refers to a sol that does not contain an additive such as potassium permanganate for providing a function as a polishing agent.

That is, in the present description, the polishing dispersion refers to one containing zirconia sol and an additive for providing a function as a polishing agent, and in the case of only the zirconia sol, the resulting dispersion cannot be qualified as the polishing dispersion.

<Polishing performance>

In the zirconia sol, it is preferable that the polishing speed when polishing is performed under the following polishing conditions using the following polishing dispersion is 0.5 μm/h or more, and the surface roughness Ra of the surface to be polished is 1.0 Å or less.

When the polishing speed is 0.5 μm/h or more and the surface roughness Ra of the surface to be polished is 1.0 Å or less, a polished surface having a low surface roughness can be obtained in a short time.

1. Preparation of polishing dispersion for evaluation of polishing performance

Ion-exchanged water and potassium permanganate are mixed with the zirconia sol, whereby a polishing dispersion containing 15.0% by mass of zirconia in terms of $ZrO_2$ and 1.2% by mass of potassium permanganate was prepared.
2. Polishing conditions

Substrate (object to be polished): 4H-SiC wafer 4-inch Si surface Off 4 degrees non-doped (surface roughness Ra: 1 Å)
Polishing device: Single-sided polishing device (EJ-380N manufactured by ENGIS Corporation)
Polishing pad: SUBA600 (NITTA DuPont)
Polishing load: 280 g/cm$^2$
Rotation speed of platen: 80 rpm (linear speed: 9.5 m/min)
Polishing time: 2 hours
Supply rate of polishing composition: 10 mL/min
Measurement area of object to be polished: 5.0 μm × 5.0 μm (measurement of surface roughness)

The polishing speed is more preferably 0.6 μm/h or more, and still more preferably 0.7 μm/h or more.
It is more favorable as the polishing speed is higher as long as the surface roughness does not exceed a certain level, but specifically, the polishing speed is more preferably 5 μm/h or less, and still more preferably 3 μm/h or less.
The polishing speed is more preferably 0.6 μm/h or more and 5 μm/h or less, and still more preferably 0.7 μm/h or more and 3 μm/h or less.
The surface roughness Ra of the surface to be polished is more preferably 0.9 Å or less, and still more preferably 0.8 Å or less.
It is more preferable as the surface roughness Ra of the surface to be polished is smaller, but is, for example, 0.1 Å or more, 0.2 Å or more, or the like.
The surface roughness Ra of the surface to be polished is more preferably 0.1 Å or more and 0.9 Å or less, and still more preferably 0.2 Å or more and 0.8 Å or less.
The zirconia sol according to the present embodiment can be obtained by, for example, the following method for producing zirconia sol.

[Method for producing zirconia sol]

Hereinafter, one example of the method for producing zirconia sol will be described. However, the method for producing zirconia sol is not limited to the following example.
The method for producing the zirconia sol according to the present embodiment includes

step A of adding ammonia water dropwise to an aqueous zirconium oxychloride solution to neutralize,
in which

(1) the concentration of the aqueous zirconium oxychloride solution before performing the step A is 10% by mass or more, and the temperature thereof is 60°C or more and 95°C or less,
(2) the concentration of the ammonia water is 10% by mass or more,
(3) the volume of droplets of the ammonia water to be dropped in the step A is 1.0 ml or less,
(4) the dropwise addition of the ammonia water is performed in two stages, and in a first stage, the ammonia water is added dropwise in an amount of 0.9 mol or more and 1.1 mol or less in terms of $NH_3$ per 1 mol of Zr, and then the resulting solution is held for 10 minutes or more and 120 minutes or less, and
(5) in a second stage, the ammonia water is further added dropwise, and then the resulting solution is held for 10 minutes or more and 120 minutes or less,
(6) during the dropwise addition of the ammonia water and during the holding, the temperature of the aqueous zirconium oxychloride solution is maintained within a range of ±5°C with respect to the temperature thereof at the start of the dropwise addition.

<Step A>

First, in the step A, ammonia water is added dropwise to an aqueous zirconium oxychloride solution to neutralize the solution.
In the present embodiment, ammonia water is used as a neutralizer for zirconium oxychloride.
The concentration of the ammonia water is 10% by mass or more.
The concentration of the ammonia water is preferably 15% by mass or more, and more preferably 20% by mass or more.

The concentration of the ammonia water does not have a particular upper limit, but is, for example, 30% by mass or less, 28% by mass or less, or the like.

The concentration of the ammonia water is preferably 15% by mass or more and 30% by mass or less, and more preferably 20% by mass or more and 28% by mass or less.

The concentration of the aqueous zirconium oxychloride solution before the step A is performed is 10% by mass or more.

The concentration of the aqueous zirconium oxychloride solution is preferably 15% by mass or more, and more preferably 18% by mass or more.

The concentration of the aqueous zirconium oxychloride solution does not have a particular upper limit, but is, for example, 28% by mass or less, 25% by mass or less, or the like.

The concentration of the aqueous zirconium oxychloride solution is preferably 15% by mass or more and 28% by mass or less, and more preferably 18% by mass or more and 25% by mass or less.

The temperature of the aqueous zirconium oxychloride solution before the step A is performed is 60°C or more and 95°C or less. The temperature mainly affects the crystallite diameter. The higher the temperature is, the larger the crystallite diameter A on the monoclinic (-111) plane and the crystallite diameter B on the monoclinic (111) plane are. Since the temperature is 60°C or more, the crystallite diameter A can be made to 5.0 nm or more and the crystallite diameter B can be made to 5.0 nm or more.

The temperature of the aqueous zirconium oxychloride solution before the step A is performed is preferably 65°C or more.

The temperature of the aqueous zirconium oxychloride solution before the step A is performed is preferably 90°C or less.

The temperature of the aqueous zirconium oxychloride solution before the step A is performed is preferably 65°C or more and 90°C or less.

The volume of droplets of the ammonia water to be dropped in the step A is 1.0 ml or less.

The volume of the droplets is preferably 0.7 ml or less, and more preferably 0.5 ml or less.

It is more preferable as the volume of the droplets is smaller, but is, for example, 0.05 ml or more, 0.1 ml or more, or the like.

The volume of the droplets is preferably 0.05 ml or more and 0.7 ml or less, and more preferably 0.1 ml or more and 0.5 ml or less.

The dropwise addition of the ammonia water is performed in two stages.

In the first stage, the ammonia water is added dropwise in an amount of 0.9 mol or more and 1.1 mol or less in terms of $NH_3$ per 1 mol of Zr, and then the resulting solution is held for 10 minutes or more and 120 minutes or less. The holding time after the dropwise addition of the ammonia water in the first stage mainly affects the crystallite diameter ratio X. The longer the holding time is, the smaller the crystallite diameter ratio X can be made. That is, by setting the holding time to 10 minutes or more, the crystallite diameter ratio X can be made to 0.95 or less. Even if the holding time is made longer than 120 minutes, it is impossible to reduce the crystallite diameter ratio X more greatly as compared with the case of holding for 120 minutes. Therefore, from the viewpoint of productivity, the holding time is 120 minutes or less.

The time of dropping the ammonia water is not particularly limited, but is preferably 10 minutes or more and 120 minutes or less, for example, in a case where 1000 ml of ammonia water is added dropwise to 1000 ml of aqueous zirconium oxychloride solution. The dropping time is more preferably 90 minutes or less, and still more preferably 60 minutes or less.

The holding time (holding time in the first stage) is preferably 20 minutes or more, and more preferably 30 minutes or more.

The holding time is preferably 100 minutes or less, and more preferably 90 minutes or less.

The holding time is preferably 20 minutes or more and 100 minutes or less, and more preferably 30 minutes or more and 90 minutes or less.

In the second stage, the ammonia water is further added dropwise, and then held for 10 minutes or more and 240 minutes or less.

The amount of the ammonia water to be added dropwise in the second stage is not limited, but is 1 mol or more and 15 mol or less, and preferably 2 mol or more and 10 mol or less in terms of $NH_3$ per 1 mol of Zr.

The time of dropping the ammonia water in the second stage is not particularly limited, but is preferably 10 minutes or more and 120 minutes or less, for example, in a case where 1000 ml of ammonia water is added dropwise to 1000 ml of aqueous zirconium oxychloride solution. The dropping time is more preferably 90 minutes or less, and still more preferably 60 minutes or less.

The holding time (holding time after the dropwise addition of the ammonia water in the second stage) is preferably 30 minutes or more, and more preferably 60 minutes or more.

The holding time is preferably 180 minutes or less, and more preferably 150 minutes or less.

The holding time is preferably 30 minutes or more and 180 minutes or less, and more preferably 60 minutes or

more and 150 minutes or less.

The holding time (holding time after the dropwise addition of the ammonia water in the second stage) mainly affects the crystallite diameter ratio Y. The longer the holding time is, the more the content of the tetragonal phase can be increased. The longer the holding time is, the smaller the crystallite diameter ratio Y can be made. That is, by setting the holding time to 30 minutes or more, the crystallite diameter ratio Y can be made to 1.2 or less. In addition, even if the holding time is made longer than 240 minutes, it is impossible to reduce the crystallite diameter ratio Y more greatly as compared with the case of holding for 240 minutes. Therefore, from the viewpoint of productivity, the holding time is 120 minutes or less.

When the holding time is less than 30 minutes, it is possible that there is no tetragonal phase, but even when there is no tetragonal phase, it is just required that the crystallite diameter ratio X is 0.5 or more and 0.95 or less. That is, when the crystallite diameter ratio X is 0.5 or more and 0.95 or less, the polishing dispersion prepared using the zirconia sol can maintain the polishing rate high and can reduce the surface roughness of the surface to be polished even when the crystallite diameter ratio Y does not satisfy 0.3 or more and 1.2 or less.

During the dropwise addition of the ammonia water and during the holding, the temperature of the aqueous zirconium oxychloride solution is maintained within a range of ±5°C with respect to the temperature thereof at the start of the dropwise addition. The temperature mainly affects the crystallite diameter. The higher the temperature is, the larger the crystallite diameter A on the monoclinic (-111) plane and the crystallite diameter B on the monoclinic (111) plane are. Since the temperature is 60°C or more, the crystallite diameter A can be made to 5.0 nm or more and the crystallite diameter B can be made to 5.0 nm or more.

According to the method for producing zirconia sol, many particles having a distorted shape are obtained by the use as a raw material of the zirconium hydroxide obtained through the control of the above (1) to (6). That is, zirconia sol in which the crystallite diameter A is 5.0 nm or more and 50.0 nm or less, the crystallite diameter B is 5.0 nm or more and 50.0 nm or less, and the crystallite diameter ratio X is 0.5 or more and 0.95 or less can be obtained. In addition, the proportion X can be easily adjusted to 40% or more.

After the step A, stirring is carried out if necessary for homogenization. A precipitate of zirconium hydroxide is thus obtained. The stirring time is not particularly limited and is, for example, 15 minutes or more and 120 minutes or less.

Thereafter, washing of zirconium hydroxide is performed if necessary. The washing is performed, for example, until the Cl concentration becomes equal to or less than a predetermined concentration. The predetermined concentration is preferably, for example, 0.01% or less. The washing method is not particularly limited, but examples thereof include a method in which an operation of separating zirconium hydroxide by filtration and dispersing zirconium hydroxide in ion-exchanged water is repeated.

<Step B>

After the step A, the zirconium hydroxide obtained in the step A is heated and aged under acidity.

For the acidification, an acid is usually added to zirconium hydroxide as a peptizer. If necessary, water may be added to adjust the concentration. The concentration is not particularly limited, but is preferably 1% by mass or more and 30% by mass or less, and more preferably 5% by mass or more and 20% by mass or less in terms of $ZrO_2$.

The peptizer for zirconium hydroxide is not particularly limited as long as it is a water-soluble inorganic acid or organic acid, examples thereof include hydrochloric acid, nitric acid, sulfuric acid, acetic acid, lactic acid, citric acid, tartaric acid, malic acid, and mandelic acid, and hydrochloric acid and nitric acid are preferable because these acids can be easily removed by purifying the zirconia sol with water after zirconia sol production even when these acids are present in excess in the zirconia sol.

As to the amount of the peptizer added, acid/$ZrO_2$ (molar ratio) is 0.01 or more and 3 or less, and more preferably 0.1 or more and 1.5 or less.

When the acid/$ZrO_2$ (molar ratio) is 0.01 or more, the peptization of zirconium hydroxide can be sufficiently carried out. The quantitative effect is small even when the acid/$ZrO_2$ (molar ratio) exceeds 3, and it is economical when the acid/$ZrO_2$ (molar ratio) is 3 or less.

Next, to peptize the zirconium hydroxide and convert the zirconium hydroxide into zirconium oxide, heating and aging are performed. The heating and aging temperature is preferably 70°C or more, and more preferably 80°C or more from the viewpoint of yield. The heating temperature is preferably 200°C or less, and more preferably 180°C or less. The heating temperature is preferably 70°C or more and 200°C or less, and more preferably 80°C or more and 180°C or less.

When the aging temperature is 70°C or more, the progress of the peptization reaction is suitable. In addition, when the aging temperature is 200°C or less, excessively strong aggregation does not occur, and dispersibility is improved.

The heating and aging time is preferably 24 hours or more, and more preferably 48 hours or more from the viewpoint of yield. The heating and aging time is preferably 120 hours or less, and more preferably 100 hours or less. The heating and aging time is preferably 24 hours or more and 120 hours or less, and more preferably 48 hours or more and 100

hours or less.

Thereafter, cooling to room temperature may be performed and then ultrafiltration may be carried out to concentrate the zirconia sol.

The acid excessively added can be easily removed by ultrafiltration.

The method for producing zirconia sol according to the present embodiment has been described above.

EXAMPLES

Hereinafter, the present invention will be described in detail with reference to Examples, but the present invention is not limited to the following Examples as long as they do not depart from the gist of the present invention. The zirconia sols in Examples and Comparative Examples contain hafnium as unavoidable impurities at 1 to 3% by mass with respect to zirconium (calculated by the following Formula (X)):

$$([\text{mass of hafnium oxide}]/([\text{mass of zirconium oxide}] + [\text{mass of hafnium oxide}])) \times 100\ (\%). \qquad \text{<Formula X>}$$

The maximum value and minimum value of the content of each component shown in the following Examples should be considered as the preferred minimum value and maximum value of the present invention regardless of the content of other components.

In addition, the maximum value and minimum value of the measured values shown in the following Examples should be considered to be the preferred minimum value and maximum value of the present invention regardless of the content (composition) of each component.

[Preparation of zirconia sol]

(Example 1)

As a first stage, to 1000 g of an aqueous zirconium oxychloride solution (10% by mass in terms of $ZrO_2$) adjusted to 60°C with a mantle heater, 138 g of ammonia water (10% by mass) adjusted to 25°C was added dropwise over 10 minutes. At this time, the number of liquid delivery tubes and the dropping speed were adjusted such that the volume of droplets of the ammonia water fell in the range of 0.1 to 0.5 ml. Thereafter, stirring was continued for 60 minutes. Thereafter, as a second stage, 1242 g of ammonia water (10% by mass) adjusted to 25°C was added dropwise over 30 minutes. Also in the second stage, the number of liquid delivery tubes and the dropping speed were adjusted such that the volume of droplets of the ammonia water fell in the range of 0.1 to 0.5 ml. Thereafter, stirring was continuously performed for 10 minutes, affording a precipitate of zirconium hydroxide. The aqueous zirconium oxychloride solution was adjusted such that the temperature thereof was maintained within a range of $\pm$5°C with respect to the initial temperature during the dropping of the ammonia water and also during the stirring after the dropping. The washing operation of separating zirconium hydroxide by filtration and dispersing the zirconium hydroxide again in ion-exchanged water was repeatedly carried out. The operation was carried out until the Cl concentration became 0.01% or less.

The concentration of zirconium hydroxide after washing was 24.0% by mass in terms of $ZrO_2$. A slurry prepared by mixing 416 g of the obtained zirconium hydroxide with 556 g of ion-exchanged water and 28.0 g of nitric acid (60% by mass) was placed in a separable flask, and held at 100°C for 120 hours with stirring under reflux, and the obtained zirconia sol precursor was purified by ultrafiltration, thereby affording the zirconia sol according to Example 1. The sol had a $ZrO_2$ concentration of 20% by mass, a pH of 3.3, and a particle diameter $D_{50}$ of 51 nm.

(Example 2)

Zirconium hydroxide was obtained in the same manner as in Example 1 except that 1000 g of an aqueous zirconium oxychloride solution (10% by mass in terms of $ZrO_2$) adjusted to 75°C with a mantle heater was used.

The concentration of zirconium hydroxide after washing was 22.8% by mass in terms of $ZrO_2$. Zirconia sol was obtained in the same manner as in Example 1 except that 533 g of ion-exchanged water and 28.0 g of nitric acid (60% by mass) were mixed with 439 g of the obtained zirconium hydroxide. The sol had a $ZrO_2$ concentration of 20% by mass, a pH of 3.1, and a particle diameter $D_{50}$ of 73 nm.

(Example 3)

Zirconium hydroxide was obtained in the same manner as in Example 1 except that 1000 g of an aqueous zirconium oxychloride solution (10% by mass in terms of $ZrO_2$) adjusted to 90°C with a mantle heater was used.

The concentration of zirconium hydroxide after washing was 21.3% by mass in terms of $ZrO_2$. Zirconia sol was obtained in the same manner as in Example 1 except that 503 g of ion-exchanged water and 28.0 g of nitric acid (60% by mass) were mixed with 469 g of the obtained zirconium hydroxide. The sol had a $ZrO_2$ concentration of 20% by mass, a pH of 3.4, and a particle diameter $D_{50}$ of 95 nm.

(Example 4)

Zirconium hydroxide was obtained in the same manner as in Example 1 except that 1000 g of an aqueous zirconium oxychloride solution (10% by mass in terms of $ZrO_2$) adjusted to 75°C with a mantle heater was used, and 138 g of ammonia water (10% by mass) adjusted to 25°C was added dropwise over 10 minutes as a first stage, and then stirring was continued for 90 minutes.

The concentration of zirconium hydroxide after washing was 22.9% by mass in terms of $ZrO_2$. Zirconia sol was obtained in the same manner as in Example 1 except that 535 g of ion-exchanged water and 28.0 g of nitric acid (60% by mass) were mixed with 437 g of the obtained zirconium hydroxide. The sol had a $ZrO_2$ concentration of 20% by mass, a pH of 3.1, and a particle diameter $D_{50}$ of 44 nm.

(Example 5)

Zirconium hydroxide was obtained in the same manner as in Example 1 except that 1000 g of an aqueous zirconium oxychloride solution (10% by mass in terms of $ZrO_2$) adjusted to 75°C with a mantle heater was used, and 1242 g of ammonia water (10% by mass) adjusted to 25°C was added dropwise over 30 minutes as a second step, and then stirring was continued for 30 minutes.

The concentration of zirconium hydroxide after washing was 23.8% by mass in terms of $ZrO_2$. Zirconia sol was obtained in the same manner as in Example 1 except that 535 g of ion-exchanged water and 28.0 g of nitric acid (60% by mass) were mixed with 420 g of the obtained zirconium hydroxide. The sol had a ZrO2 concentration of 20% by mass, a pH of 3.3, and a particle diameter $D_{50}$ of 43 nm.

(Example 6)

Zirconium hydroxide was obtained in the same manner as in Example 1 except that 1000 g of an aqueous zirconium oxychloride solution (10% by mass in terms of $ZrO_2$) adjusted to 75°C with a mantle heater was used, and 1242 g of ammonia water (10% by mass) adjusted to 25°C was added dropwise over 30 minutes as a second step, and then stirring was continued for 60 minutes.

The concentration of zirconium hydroxide after washing was 23.2% by mass in terms of $ZrO_2$. Zirconia sol was obtained in the same manner as in Example 1 except that 541 g of ion-exchanged water and 28.0 g of nitric acid (60% by mass) were mixed with 431 g of the obtained zirconium hydroxide. The sol had a ZrO2 concentration of 20% by mass, a pH of 3.2, and a particle diameter $D_{50}$ of 39 nm.

(Example 7)

Zirconium hydroxide was obtained in the same manner as in Example 1 except that 1000 g of an aqueous zirconium oxychloride solution (10% by mass in terms of $ZrO_2$) adjusted to 75°C with a mantle heater was used, and 1242 g of ammonia water (10% by mass) adjusted to 25°C was added dropwise over 30 minutes as a second step, and then stirring was continued for 120 minutes.

The concentration of zirconium hydroxide after washing was 22.6% by mass in terms of $ZrO_2$. Zirconia sol was obtained in the same manner as in Example 1 except that 530 g of ion-exchanged water and 28.0 g of nitric acid (60% by mass) were mixed with 442 g of the obtained zirconium hydroxide. The sol had a $ZrO_2$ concentration of 20% by mass, a pH of 3.3, and a particle diameter $D_{50}$ of 34 nm.

(Comparative Example 1)

To 1000 g of an aqueous zirconium oxychloride solution (10% by mass in terms of $ZrO_2$) adjusted to 25°C, 1,380 g of ammonia water (10% by mass) adjusted to 25°C was added dropwise over 40 minutes. At this time, the number of liquid delivery tubes and the dropping speed were adjusted such that the volume of droplets of the ammonia water fell in the range of 0.1 to 0.5 ml. Thereafter, stirring was continuously performed for 10 minutes, affording a precipitate of zirconium hydroxide. The washing operation of separating zirconium hydroxide by filtration and dispersing the zirconium hydroxide again in ion-exchanged water was repeatedly carried out. The operation was carried out until the Cl concentration became 0.01% or less.

The concentration of zirconium hydroxide after washing was 28.4% by mass in terms of $ZrO_2$. Zirconia sol was obtained in the same manner as in Example 1 except that 620 g of ion-exchanged water and 28.0 g of nitric acid (60% by mass) were mixed with 352 g of the obtained zirconium hydroxide. The sol had a $ZrO_2$ concentration of 20% by mass, a pH of 3.3, and a particle diameter $D_{50}$ of 72 nm.

(Comparative Example 2)

A sheath made of cordierite was filled with 3000 g of zirconium hydroxide obtained in the same manner as in Example 1, and then fired by holding in a batch type electric furnace while maintaining the temperature at 1150°C for 10 hours, whereby zirconium oxide was obtained. A mixture of 600 g of the obtained zirconium oxide, 1400 g of ion-exchanged water, and 5.0 g of nitric acid (60% by mass) was pulverized with a bead mill using a pulverizing medium made of zirconium oxide having a diameter of 0.3 mm, affording zirconia sol. The sol had a $ZrO_2$ concentration of 20% by mass, a pH of 3.2, and a particle diameter $D_{50}$ of 236 nm.

[Measurement of particle diameter $D_{50}$]

The zirconia sol according to each of Examples and Comparative Examples was diluted with ion-exchanged water to a concentration of 1.0% by mass in terms of $ZrO_2$, and then injected into a device (dynamic light scattering particle size distribution measuring device ("Zetasizer Nano ZS" manufactured by Malvern Panalytical)), and the particle diameter $D_{50}$ (on the basis of volume frequency distribution) of the zirconia sol was measured. The results are shown in Table 1.

<Measurement conditions>

Measurement temperature: 25°C
Scattering angle: 173°
Dispersoid: $ZrO_2$
Dispersion medium: Water
Cell: Genuine disposable cell
Number of repetitions: 3 (The particle diameter $D_{50}$ was an average value of 3 times of measurement.)

[Powder X-ray diffraction measurement and analysis]

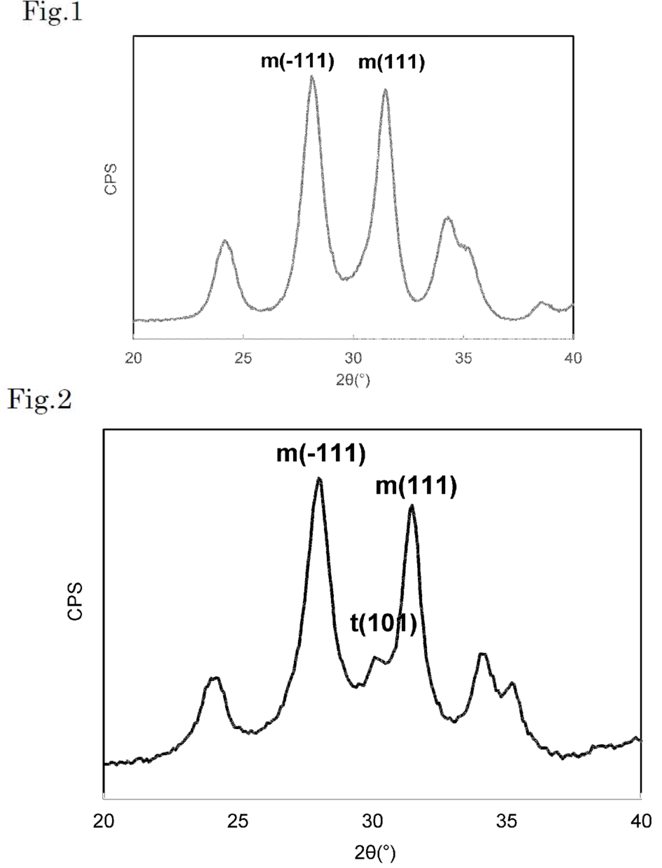

A material obtained by drying, at 100°C, the zirconia sol obtained in each of Examples and Comparative Examples was measured with an X-ray diffractometer ("RINT2500" manufactured by Rigaku Corporation), whereby an X-ray diffraction chart was obtained. The measurement conditions were as follows. Fig. 1 shows an X-ray diffraction chart of Example 1, and Fig. 2 shows an X-ray diffraction chart of Example 5.

<Measurement conditions>

Measuring device: X-ray diffractometer (RINT2500, manufactured by Rigaku Corporation)
Radiation source: CuK$\alpha$ radiation source
Tube voltage: 50 kV
Tube current: 300 mA
Scanning angle: $2\theta$ = 10 to 50°
Scanning speed: 1°/min

The range of $2\theta$ = 20 to 40° of the chart was analyzed by Powder XRD, SmartLab Studio II (RIGAKU), and the crystallite diameter on each crystal plane and the tetragonal crystal fraction were calculated. The results are shown in Table 1. In Table 1, the crystallite diameter ratio X ([crystallite diameter A on monoclinic (-111) plane]/[crystallite diameter B on monoclinic (111) plane]) and the crystallite diameter ratio Y ([crystallite diameter A on monoclinic (-111) plane]/[crystallite diameter C on tetragonal (101) plane]) are also shown.

For this calculation, three peaks whose peak tops were located in the ranges of 27.5 to 28.5°, 29.5 to 30.5°, and 31.0 to 32.0° of the diffraction chart were targeted. 27.5 to 28.5° is assigned to m (-111), 29.5 to 30.5° is assigned to t (101) or c (111), and 31.0 to 32.0° is assigned to m (111). When this peak angle deviates from the above ranges due to a change in

lattice constant due to solid solution of another element in zirconia, even if the peak is split, the zirconia sample can be subjected to this analysis if it is appropriate that the peak is assigned to any of the crystal planes. In the present description, t (101) and c (111) do not necessarily need to be identified, and are treated as the same.

For the analysis, the following operation and conditions were used.

After reading the X-ray powder diffraction measurement data in the software Powder XRD in SmartLab Studio II, peak processing is performed.

Peak profiling conditions are set as follows.

Peak search: checkbox ON
Pre-processing: customization
Method: second derivative method
$\sigma$ Cut value: 3 (If no clearly visible peak is detected, the cut value is adjusted between 0.5 to 3.)
Profile fitting: checkbox ON
Peak shape: divided pseudo-Voigt function

Background type: B-spline

Fitting conditions: automatic
Refining background: checkbox ON

For the calculation of the crystallite diameter and the crystallite diameter ratio, the value (the parenthesized value is ignored) displayed in the column of the crystallite size (Å) displayed by the peak list tab is used.

For the calculation of the tetragonal crystal fraction, the value (the parenthesized value is ignored) displayed in the column of the integrated intensity (count°) displayed by the peak list tab is used.

The tetragonal phase fraction was calculated from the following formula based on the diffraction peak intensity I of each crystal plane obtained by the above analysis.

$$[\text{tetragonal phase fraction (\%)}] = \{It\ (101) + Ic\ (111)\}/\{It\ (101) + Ic\ (111) + Im\ (-111) + Im\ (111)\} \times 100$$

Here, Im (-111) is the diffraction intensity of (-111) in the monoclinic phase, and Im (111) is the diffraction intensity of (111) in the monoclinic phase.

It (101) is the diffraction intensity of (101) in the tetragonal phase.

Ic (111) is the diffraction intensity of (111) in the cubic phase.

[Measurement of particle shape]

First, a TEM image (transmission electron microscope image) of the zirconia sol according to each of Examples and Comparative Examples was acquired. A transmission electron microscope (product name: HV-8100 manufactured by Hitachi, Ltd.) was used to take the TEM image, and the size of one visual field was set to 1.15 $\mu$m $\times$ 0.90 $\mu$m.

Next, the number of isolated particles was visually counted. Specifically, the number of particles in which the diameter of the circumscribed circle circumscribing the particle was 70% or more of the particle diameter $D_{50}$ of the zirconia sol was counted. In a case where there were a plurality of circumscribed circles circumscribing the particle, one having the smallest ratio (see "2)" below) of the diameter of the circumscribed circle to the diameter of the inscribed circle (concentric inscribed circle) having the same center as that of the circumscribed circle was adopted. The reason why particles in which the diameter of the circumscribed circle circumscribing the particle was less than 70% of the particle diameter $D_{50}$ of the zirconia sol were not counted is because such particles have a low effect as a polishing agent.

In a case where the number of isolated particles was 20 or more, the TEM image was used as the image to be evaluated. In a case where the number of isolated particles was less than 20, a TEM image of a different visual field was taken, and this was repeated until a TEM image having 20 or more isolated particles was acquired.

The following operation was carried out for each isolated particle (the isolated particle to be counted) in the acquired TEM image.

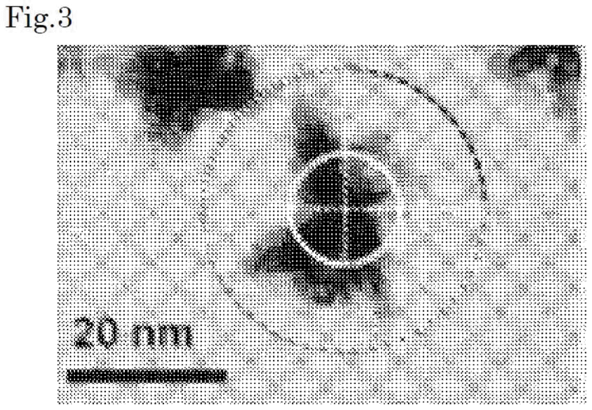

1) First, a circumscribed circle of a particle and an inscribed circle (concentric inscribed circle) having the same center as that of the circumscribed circle were determined (see Fig. 3). The definitions of the circumscribed circle and inscribed circle are the same as those in the MCC method for circularity in JIS B 7451:1997.
2) Next, the ratio [(diameter of circumscribed circle)/(diameter of inscribed circle)] of the diameter of the obtained circumscribed circle to the diameter of the obtained inscribed circle was determined.

3) The ratio [(diameter of circumscribed circle)/(diameter of inscribed circle)] was determined for all of the isolated particles (all isolated particles to be counted) in the TEM image.
4) The number of isolated particles having the ratio [(diameter of circumscribed circle)/(diameter of inscribed circle)] of 2.0 or more (hereinafter, also referred to as "isolated particles A") was counted.
5) The proportion of isolated particles A to all isolated particles (all isolated particles to be counted) (hereinafter, also referred to as "proportion X") was determined.

(Proportion X (%)) = [(number of isolated particles A)/(number of all isolated particles)] × 100.

The results are shown in Table 1.
Fig. 3 is a drawing example when the proportion X was calculated in Example 1, and in this example, the diameter of the circumscribed circle was 36.0 nm and the diameter of the inscribed circle was 13.8 nm.

[Polishing performance evaluation]

Zirconia sol of each of Examples and Comparative Examples was mixed with ion-exchanged water and potassium permanganate, whereby a polishing dispersion of 15% by mass in terms of $ZrO_2$ and 1.2% by mass in terms of $KMO_4$ was prepared. The SiC wafer was polished using this polishing dispersion, and the polishing speed and the surface roughness Ra of the surface to be polished were measured.
The polishing conditions were set as follows.

Substrate (object to be polished): 4H-SiC wafer 4-inch Si surface Off 4 degrees non-doped (surface roughness Ra: 1 Å)
Polishing device: Single-sided polishing device (EJ-380N manufactured by ENGIS Corporation)
Polishing pad: SUBA600 (NITTA DuPont)
Polishing load: 280 g/cm$^2$
Rotation speed of platen: 80 rpm (linear speed: 9.5 m/min)
Polishing time: 2 hours
Supply rate of polishing composition: 10 mL/min
Measurement area of object to be polished: 5.0 μm × 5.0 μm (measurement of surface roughness)

The polishing speed was calculated from the difference between the weights of the substrate measured before and after polishing.
The surface roughness (arithmetic average roughness (Ra)) of the surface to be polished of the object to be polished after polishing was measured using AFM "Dimension Edge" manufactured by Bruker under the condition with a viewing angle of 5.0 μm × 5.0 μm. The results are shown in Table 1.

[Table 1]

| | Temperature of aqueous zirconium oxychloride solution (°C) | Dropwise addition of ammonia water | | Particle diameter $D_{50}$ (nm) | Crystal plane | Crystallite diameter (nm) | Crystallite diameter ratio X | Tetragonal crystal fraction (%) | Crystallite diameter ratio Y | Proportion X (%) | Polishing rate (μm/h) | Surface roughness Ra (Å) |
|---|---|---|---|---|---|---|---|---|---|---|---|---|
| | | Holding time in first stage (min) | Holding time in second stage (min) | | | | | | | | | |
| Example 1 | 60 | 60 | 10 | 51 | m (-111) | 6.2 | 0.65 | 0 | - | 54 | 0.63 | 0.52 |
| | | | | | m (111) | 9.6 | | | | | | |
| Example 2 | 75 | 60 | 10 | 73 | m (-111) | 10.2 | 0.73 | 0 | - | 62 | 0.91 | 0.46 |
| | | | | | m (111) | 14.0 | | | | | | |
| Example 3 | 90 | 60 | 10 | 95 | m (-111) | 25.9 | 0.91 | 0 | - | 59 | 1.03 | 0.58 |
| | | | | | m (111) | 28.5 | | | | | | |
| Example 4 | 75 | 90 | 10 | 44 | m (-111) | 9.2 | 0.63 | 0 | - | 72 | 1.07 | 0.45 |
| | | | | | m (111) | 14.6 | | | | | | |
| Example 5 | 75 | 60 | 30 | 43 | m (-111) | 8.2 | 0.75 | 7.6 | 0.84 | 72 | 0.82 | 0.35 |
| | | | | | m (111) | 11.0 | | | | | | |
| | | | | | t (101) | 9.8 | | | | | | |
| Example 6 | 75 | 60 | 60 | 39 | m (-111) | 8.0 | 0.74 | 18.9 | 0.77 | 70 | 0.90 | 0.38 |
| | | | | | m (111) | 10.8 | | | | | | |
| | | | | | t (101) | 10.4 | | | | | | |
| Example 7 | 75 | 60 | 120 | 34 | m (-111) | 8.5 | 0.75 | 42.4 | 0.66 | 57 | 0.86 | 0.37 |
| | | | | | m (111) | 11.4 | | | | | | |
| | | | | | t (101) | 12.9 | | | | | | |
| Comparative Example 1 | 25 | 10 | - | 72 | m (-111) | 4.6 | 0.96 | 0 | - | 48 | 0.29 | 0.55 |
| | | | | | m (111) | 4.8 | | | | | | |
| Comparative Example 2 | 60 | 60 | 10 | 236 | m (-111) | 64.6 | 1.01 | 0 | - | 35 | 0.91 | 1.36 |
| | | | | | m (111) | 64.1 | | | | | | |

## Claims

**1.** Zirconia sol in which

a crystallite diameter A on a monoclinic (-111) plane is 5.0 nm or more and 50.0 nm or less,
a crystallite diameter B on a monoclinic (111) plane is 5.0 nm or more and 50.0 nm or less, and
a crystallite diameter ratio X represented by the following Formula 1 is 0.5 or more and 0.95 or less:

[crystallite diameter ratio X] = [crystallite diameter A on monoclinic (-111) plane]/[crystallite diameter B on monoclinic (111) plane] <Formula 1>

where the crystallite diameter A and the crystallite diameter B are values calculated from powder X-ray diffraction measurement and analysis of the measurement.

**2.** The zirconia sol according to claim 1, comprising a tetragonal phase in a volume fraction of 2.0% or more and 90.0% or less.

**3.** The zirconia sol according to claim 1 or 2, wherein a crystallite diameter ratio Y represented by the following Formula 2 is 0.3 or more and 1.2 or less:

[crystallite diameter ratio Y] = [crystallite diameter A on monoclinic (-111) plane]/[crystallite diameter C on tetragonal (101) plane] <Formula 2>

where the crystallite diameter C is a value calculated from powder X-ray diffraction measurement and analysis of the measurement.

**4.** The zirconia sol according to claim 1 or 2, in which

a particle diameter $D_{50}$ is within a range of 5 nm or more and less than 50 nm, and
a proportion X attained by the following procedure is 40% or more:
<Procedure>

a transmission electron microscope image in which 20 or more isolated particles are included is obtained;
the following operations 1) through 5) are carried out with respect to each isolated particle in the transmission electron microscope image:

1) a circumscribed circle and an inscribed circle which has the same center as that of the circumscribed circle are obtained;
2) a ratio of the diameter of the obtained circumscribed circle and the diameter of the obtained inscribed circle [(diameter of circumscribed circle)/(diameter of inscribed circle)] is obtained;
3) the ratio defined above [(diameter of circumscribed circle)/(diameter of inscribed circle)] is obtained for all the isolated particles in the transmission electron microscope image;
4) the number of isolated particles A having a ratio [(diameter of circumscribed circle)/(diameter of inscribed circle)] of 2.0 or more is counted;
5) the proportion X of the isolated particles A to all the isolated particles is obtained:

(proportion X (%)) = [(number of isolated particles A)/(number of all isolated particles)] × 100.

**5.** A method for producing the zirconia sol according to claim 1 or 2, comprising step A of adding ammonia water dropwise to an aqueous zirconium oxychloride solution to neutralize,
wherein

(1) a concentration of the aqueous zirconium oxychloride solution before performing the step A is 10% by mass or more, and a temperature thereof is 60°C or more and 95°C or less,
(2) a concentration of the ammonia water is 10% by mass or more,
(3) a volume of droplets of the ammonia water to be dropped in the step A is 1.0 ml or less,

(4) the dropwise addition of the ammonia water is performed in two stages, and in a first stage, the ammonia water is added dropwise in an amount of 0.9 mol or more and 1.1 mol or less in terms of $NH_3$ per 1 mol of Zr, and then a resulting solution is held for 10 minutes or more and 120 minutes or less, and
(5) in a second stage, the ammonia water is further added dropwise, and then a resulting solution is held for 10 minutes or more and 240 minutes or less,
(6) during the dropwise addition of the ammonia water and during the holding, a temperature of the aqueous zirconium oxychloride solution is maintained within a range of ±5°C with respect to a temperature thereof at a start of the dropwise addition.

**6.** The method for producing the zirconia sol according to claim 5, wherein a holding time in the second stage is 30 minutes or more and 240 minutes or less.

Fig.1

m(-111)
m(111)
CPS
20
25
30
35
40
2θ(°)

Fig.2

m(-111)
m(111)
t(101)
CPS
20
25
30
35
40
2θ(°)

Fig.3

20 nm

## INTERNATIONAL SEARCH REPORT

International application No.
**PCT/JP2024/035740**

**A. CLASSIFICATION OF SUBJECT MATTER**

***C01G 25/02***(2006.01)i; ***C09K 3/14***(2006.01)i; ***H01L 21/304***(2006.01)i
FI: C01G25/02; C09K3/14 550D; C09K3/14 550Z; H01L21/304 622B

According to International Patent Classification (IPC) or to both national classification and IPC

**B. FIELDS SEARCHED**

Minimum documentation searched (classification system followed by classification symbols)

C01G25/02; C09K3/14; H01L21/304; C09G1/00; B24B; B24C; B24D

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JST7580/JSTChina (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | JP 2016-069213 A (DAIICHI KIGENSO KAGAKU KOGYO CO., LTD.) 09 May 2016 (2016-05-09)<br>comparative example 1, fig. 1 | 1 |
| X | JP 2019-202901 A (SHOWA DENKO K.K.) 28 November 2019 (2019-11-28)<br>paragraph [0032], examples 1-3, table 1, fig. 1 | 1-3 |
| X | JP 2010-105892 A (KANTO DENKA KOGYO CO., LTD.) 13 May 2010 (2010-05-13)<br>claims, examples, table 1 | 1 |
| Y | | 2-3 |
| X | JP 2005-170700 A (HITACHI MAXELL LTD.) 30 June 2005 (2005-06-30)<br>claims, examples 1, 3 | 1 |
| Y | | 2-3 |
| Y | JP 2023-147178 A (FUJIMI INC.) 12 October 2023 (2023-10-12)<br>claims, paragraphs [0026], [0061], examples 1, 4-10 | 2-3 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **22 November 2024** | **03 December 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No.
**PCT/JP2024/035740**

**C. DOCUMENTS CONSIDERED TO BE RELEVANT**

| Category* | Citation of document, with indication, where appropriate, of the relevant passages | Relevant to claim No. |
|---|---|---|
| A | JP 2014-504324 A (SAINT-GOBAIN CERAMICS & PLASTICS, INC.) 20 February 2014 (2014-02-20)<br>entire text | 1-6 |
| A | JP 2005-330174 A (DAIICHI KIGENSO KAGAKU KOGYO CO., LTD.) 02 December 2005 (2005-12-02)<br>fig. 1-3 | 1-6 |

Form PCT/ISA/210 (second sheet) (July 2022)

**INTERNATIONAL SEARCH REPORT**
**Information on patent family members**

International application No.
**PCT/JP2024/035740**

| Patent document cited in search report | Publication date (day/month/year) | Patent family member(s) | Publication date (day/month/year) |
|---|---|---|---|
| JP 2016-069213 A | 09 May 2016 | US 2016/0243515 A1<br>comparative example 1, fig. 1<br>WO 2016/051870 A1<br>EP 3026017 A1<br>CN 105658583 A | |
| JP 2019-202901 A | 28 November 2019 | (Family: none) | |
| JP 2010-105892 A | 13 May 2010 | (Family: none) | |
| JP 2005-170700 A | 30 June 2005 | (Family: none) | |
| JP 2023-147178 A | 12 October 2023 | US 2023/0312980 A1<br>claims, paragraphs [0026], [0085], examples 1, 4-10<br>CN 116891724 A<br>KR 10-2023-0141967 A<br>TW 202342666 A | |
| JP 2014-504324 A | 20 February 2014 | US 2012/0171936 A1<br>entire text<br>WO 2012/092361 A2<br>EP 2658943 A2<br>TW 201226547 A<br>CN 103328598 A<br>KR 10-2013-0108433 A | |
| JP 2005-330174 A | 02 December 2005 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006324639 A
- WO 2012169515 A
- WO 06123562 A
- JP 2137732 A
- JP 5024844 A